(19) Europäisches Patentamt
European Patent Office
Office européen des brevets

(11) Veröffentlichungsnummer: **0 184 044 B1**

(12) **EUROPÄISCHE PATENTSCHRIFT**

(45) Veröffentlichungstag der Patentschrift: **15.01.92**

(51) Int. Cl.$^5$: **G03F 7/022**

(21) Anmeldenummer: **85114454.3**

(22) Anmeldetag: **14.11.85**

(54) **Strahlungsempfindliches Gemisch, daraus hergestelltes Aufzeichnungsmaterial und Verfahren zur Herstellung von wärmebeständigen Reliefaufzeichnungen.**

(30) Priorität: **23.11.84 DE 3442756**

(43) Veröffentlichungstag der Anmeldung:
**11.06.86 Patentblatt 86/24**

(45) Bekanntmachung des Hinweises auf die Patenterteilung:
**15.01.92 Patentblatt 92/03**

(84) Benannte Vertragsstaaten:
**AT BE CH DE FR GB IT LI NL SE**

(56) Entgegenhaltungen:
**EP-A- 0 153 682**
**CH-A- 534 374**
**DE-A- 2 309 062**
**DE-A- 3 309 222**
**DE-A- 3 329 443**

**PATENT ABSTRACTS OF JAPAN, Band 7, Nr. 253 (P-235)[1398], 10. November 1983; & JP-A-58 137 834 (KURARAY K.K.) 16-08-1983**

(73) Patentinhaber: **HOECHST AKTIENGESELLSCHAFT**
**Postfach 80 03 20**
**W-6230 Frankfurt am Main 80(DE)**

(72) Erfinder: **Schneller, Arnold, Dr. Dipl.-Chem.**
**Asternweg 41**
**W-6500 Mainz 21(DE)**
Erfinder: **Geissler, Ulrich, Dr. Dipl.-Chem.**
**Altenauer Strasse 34**
**W-6203 Hochheim/M.(DE)**

EP 0 184 044 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein positiv arbeitendes strahlungs- bzw. lichtempfindliches Gemisch, das als wesentliche Bestandteile

A) ein in Wasser unlösliches, in wäßrig-alkalischen Lösungen lösliches polymeres Bindemittel und

B) ein 1,2-Chinondiazid oder eine Kombination aus

1.) einer unter Einwirkung von aktinischer Strahlung eine starke Säure bildenden Verbindung und

2.) einer Verbindung mit mindestens einer spaltbaren C-O-C-Bindung enthält, deren Löslichkeit in einem flüssigen Entwickler durch Einwirkung von Säure erhöht wird,

sowie ein strahlungsempfindliches Aufzeichnungsmaterial aus einem mit einer Schicht aus diesem Gemisch überzogenen Schichtträger, das zur Herstellung von Druckplatten und Photoresists geeignet ist.

Positiv arbeitende lichtempfindliche Gemische, d.h. Gemische, deren Kopierschicht an den belichteten Stellen löslich wird, aus den genannten Bestandteilen sind bekannt.

Diese Gemische enthalten als alkalilösliche Bindemittel in der überwiegenden Mehrzahl Phenol-Formaldehyd-Kondensate, insbesondere Novolake. Als weitere mögliche alkalilösliche Bindemittel werden Homo- und Copolymere des Vinylphenols, Copolymere aus Maleinsäureanhydrid und Styrol, aus Vinylacetat und Crotonsäure, von Methylmethacrylat und Methacrylsäure oder durch Chloressigsäure modifizierte Novolake beschrieben. Diese weiteren Bindemittel haben sich jedoch in der Praxis nicht durchgesetzt. Praktisch alle bekannten kommerziellen Formulierungen enthalten deshalb Novolake. Für bestimmte Anwendungszwecke sind diese Novolake als Bindemittel jedoch weniger geeignet.

Ein prinzipieller Nachteil der Novolake ist die nicht ausreichende thermische Stabilität. Wird bei der Herstellung von integrierten Schaltungen durch Photoresisttechnik trockenes Plasmaätzen eingesetzt, so muß der verwendete Photoresist die dabei auftretenden hohen Temperaturen ohne Verformung oder Veränderung des Bildes überstehen. Diese Anforderung wird von den üblicherweise verwendeten Novolaken nicht erfüllt. Bedingt durch den Erweichungsbereich der Novolake von 120 - 130 °C beginnen die Resists oberhalb dieser Temperaturen zu fließen. Als Folge davon verlaufen die Strukturen und führen zu einer geringeren Auflösung.

Ein ähnlicher Nachteil der Novolake tritt bei deren Einsatz als Bindemittel in Positivdruckplatten auf. Zur Erhöhung der Druckauflage werden die Druckplatten nach dem Belichten und Entwickeln einige Minuten bei Temperaturen um ca. 200 - 250 °C eingebrannt. Hierbei können Teile des Novolaks und sonstige Schichtbestandteile aus der Schicht entweichen und sich auf der freigelegten Aluminiumoberfläche festsetzen, was beim Druckprozeß zum Tonen, d. h. zu unerwünschter Farbannahme an Nichtbildstellen führt.

Beim Einsatz von Positivschichten im Trockenresistverfahren ist eine weiche und flexible Schicht erforderlich, um eine einwandfreie Verarbeitung zu gewährleisten. Die Weichheit der Schicht kann beim anschließenden Galvanisieren zu Problemen führen, z. B. durch Ausdiffundieren von niedermolekularen Schichtbestandteilen und Unterwandern von Resistflanken.

Um die genannten Nachteile zu vermeiden, sind schon verschiedene Vorschläge bekanntgeworden.

In der DE-A 33 09 222 werden o-Chinondiazide mit Polyvinylphenolen kombiniert. Aufgrund des hohen Erweichungsbereiches (über 150 °C) des eingesetzten Polyvinylphenols lassen sich zwar Resiste erhalten, die höhere Temperaturen ohne Verzerrung des Bildes aushalten, gleichzeitig wirkt sich dieser Parameter jedoch nachteilig auf die mechanischen Eigenschaften einer solchen Resiscschicht aus. Eine Verarbeitung als Trockenresist von der Rolle ist ausgeschlossen, da dieses Verfahren beim Laminieren auf ein Substrat ein thermoplastisches Fließen bei ca. 100 - 130 °C erfordert. Außerdem sind derartige Schichten sehr spröde und neigen leicht zu Absplitterungen beim Beschneiden.

Ein Gemisch mit erhöhter Lichtempfindlichkeit ist in den Patent Abstracts of Japan, Vol. 7, No. 253 (P-235) [1398], 10. November 1983 (JP-A 58-137 837), beschrieben. Das Gemisch enthält einen modifizierten Polyvinylalkohol als Bindemittel und ein Kondensationsprodukt aus Diphenylamin-4-diazonium-chlorid und Formaldehyd als lichtempfindliche Substanz.

In der DE-A 32 31 147 wird ein positiv arbeitendes Gemisch beschrieben, das neben den lichtempfindlichen o-Nitrocarbinolestergruppierungen vernetzend wirkende Verbindungen enthält, die unter dem Einfluß von Wärme mit den nach der Belichtung vorliegenden Carboxylgruppen unter Bildung einer kovalenten Bindung reagieren. Neben der bekannten geringen Lichtempfindlichkeit der o-Nitrocarbinolester besitzt dieses Verfahren den Nachteil, daß nach dem bildmäßigen Belichten und Entwickeln eine zweite vollflächige Belichtung erforderlich ist, um die Resistschicht thermisch vernetzen zu können.

Als weitere Möglichkeit werden in den DE-A 30 39 926 und 32 46 037 niedermolekulare Verbindungen mit vernetzungsfähigen Methylol-, Methylolether- oder Methylolestergruppen als Zusätze zu Gemischen aus o-Chinondiaziden und Novolaken beschrieben, die bei erhöhten Temperaturen eine thermische Vernetzung mit dem Novolak und dadurch eine Erhöhung der Druckauflage bewirken. Diese Zusätze können jedoch beim Einbrennen oder in Galvanobädern aus der Schicht entweichen und zu Problemen führen.

In der älteren, nicht vorveröffentlichten DE-A 33 29 443 wird ein photopolymerisierbares Gemisch beschrieben, das ethylenisch ungesättigte polymerisierbare Verbindungen, Bindemittel und Photoinitiatoren sowie ein Bindemittel mit seitenständigen thermisch vernetzbaren Gruppen der Formel $-CH_2OR$ enthält, worin R H, eine Alkyl-, Acyl- oder Hydroxyalkylgruppe ist.

Aufgabe der Erfindung war es, ein positiv arbeitendes strahlungsempfindliches Gemisch der eingangs beschriebenen Gattung bereitzustellen, das die Herstellung von Reliefbildern oder Resists mit hoher Auflösung, guter thermischer Beständigkeit und Resistenz gegenüber Lösungsmitteln, Ätzlösungen und galvanischen Bädern erlaubt und keine Bestandteile enthält, die beim Erwärmen flüchtige Produkte abgeben, die den Bildhintergrund verschlechtern.

Erfindungsgemäß wird ein strahlungsempfindliches Gemisch vorgeschlagen, das

A) ein in Wasser unlösliches, in wäßrig-alkalischen Lösungen lösliches polymeres Bindemittel und

B) ein 1,2-Chinondiazid oder eine Kombination aus

1.) einer unter Einwirkung von aktinischer Strahlung eine starke Säure bildenden Verbindung und

2.) einer Verbindung mit mindestens einer spaltbaren C-O-C-Bindung enthält, deren Löslichkeit in einem flüssigen Entwickler durch Einwirkung von Säure erhöht wird.

Das erfindungsgemäße Gemisch ist dadurch gekennzeichnet, daß es als Bindemittel ein Polymeres mit seitenständigen vernetzenden Gruppen der Formel $-CH_2OR$ enthält, worin R ein Wasserstoffatom, eine niedere Alkyl-, Acyl- oder Hydroxyalkylgruppe ist.

Erfindungsgemäß wird auch ein strahlungsempfindliches Aufzeichnungsmaterial mit einem Schichtträger und einer strahlungsempfindlichen Schicht vorgeschlagen, die die oben angegebene Zusammensetzung hat.

Erfindungsgemäß wird schließlich auch ein Verfahren zur Herstellung von wärmebeständigen Reliefaufzeichnungen vorgeschlagen, bei dem man ein Aufzeichnungsmaterial der vorstehend angegebenen Beschaffenheit bildmäßig belichtet, mit einer wäßrig-alkalischen Entwicklerlösung entwickelt und das erhaltene Reliefbild auf erhöhte Temperatur erwärmt.

Das erfindungsgemäße Verfahren ist dadurch gekennzeichnet, daß die Photoresistschicht als Bindemittel ein Polymeres mit seitenständigen vernetzenden Gruppen der Formel $CH_2OR$ enthält, worin R ein Wasserstoffatom, eine niedere Alkyl-, Acyl- oder Hydroxyalkylgruppe ist, und daß man die entwickelte Schicht 2 bis 60 Minuten auf eine Temperatur im Bereich von 80 bis 250 °C erwärmt.

Die vernetzenden Gruppen $-CH_2OR$ stehen im allgemeinen an einem aromatischen Ringkohlenstoffatom oder an einem Amidstickstoffatom.

Das Polymere ist bevorzugt ein Mischpolymerisat mit Einheiten der Formel I

$$\begin{array}{c} R'' \\ | \\ -CH_2-C- \\ | \\ CO \\ | \\ NR' \\ | \\ CH_2 \\ | \\ OR \end{array}$$

worin

R' ein Wasserstoffatom oder eine Alkylgruppe,

R'' ein Wasserstoffatom oder eine Methylgruppe ist und

R die oben angegebene Bedeutung hat.

Wenn R' eine Alkylgruppe ist, enthält diese im allgemeinen 1 bis 6, bevorzugt 1 oder 2 Kohlenstoffatome. Besonders bevorzugt werden Verbindungen mit R' = H oder Methyl.

Wenn R eine Alkylgruppe ist, enthält diese im allgemeinen 1 bis 6, bevorzugt 1 bis 4 Kohlenstoffatome; wenn es eine Acylgruppe ist, hat diese im allgemeinen 1 bis 4, bevorzugt 1 bis 2 Kohlenstoffatome. Verbindungen mit R = Alkyl werden im allgemeinen bevorzugt.

Außer den Einheiten der oben angegebenen Formel kann das Mischpolymerisat weitere Einheiten enthalten.

Die Polymeren mit den oben bezeichneten Monomereinheiten ergeben beim Erhitzen in Gegenwart von Polymeren mit freien Hydroxyl- oder Carboxylgruppen vernetzte Produkte. Sie können demgemäß im Gemisch mit polymeren Bindemitteln vorliegen, die solche Substituenten enthalten. Bevorzugt werden Bindemittel verwendet, die beide Arten von funktionellen Einheiten, d. h. Einheiten der Formel I und Einheiten mit freien OH- oder

COOH-Gruppen, in einem Molekül enthalten.

Als Monomereinheiten mit freien Hydroxygruppen können sowohl Verbindungen mit aliphatischen als auch aromatischen Hydroxygruppen eingesetzt werden.

Als Einheiten mit aliphatischen Hydroxygruppen kommen z. B. in Betracht: Hydroxyalkylacrylate und -methacrylate, Hydroxyalkoxyalkylacrylate und -methacrylate, Glycerinmonoacrylat und -methacrylat und Trimethylolpropanmonoacrylat und -methacrylat, Hydroxyalkylvinylether und Vinylalkohol.

Einheiten mit aromatischen Hydroxygruppen werden im allgemeinen bevorzugt, weil sie zugleich die gewünschte Alkalilöslichkeit vermitteln.

Die verwendbaren Einheiten mit aromatischen Hydroxygruppen lassen sich allgemein durch folgende Formel ausdrücken:

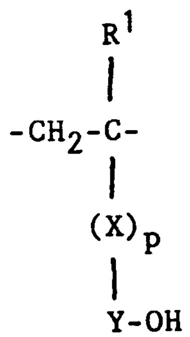

Dabei bedeuten

- $R^1$ ein Wasserstoffatom, eine Alkylgruppe, ein Halogenatom oder eine Cyanogruppe,
- Y eine substituierte oder unsubstituierte ein- oder zweikernige aromatische Gruppe,
- X ein zweiwertiges Bindeglied und
- p = 0 oder 1.

Y ist bevorzugt eine gegebenenfalls durch Halogenatome, Alkyl- oder Alkoxygruppen mit 1 - 4 Kohlenstoffatomen substituierte einkernige aromatische Gruppe. Zweikernige Gruppen können in gleicher Weise substituiert sein. X kann bevorzugt eine Säureamid- oder Carbonsäureestergruppierung sein oder eine derartige Gruppierung enthalten.

Bevorzugte Beispiele für derartige Einheiten sind N-(4-Hydroxyphenyl)methacrylamid, N-(3-Hydroxyphenyl)-acrylamid und N-(5-Hydroxynaphth-1-yl)methacrylamid, o-, m- und p-Hydroxyphenylacrylat oder -methacrylat, 2-Hydroxy-3-(3'- hydroxybenzoyloxy)propylmethacrylat, 2-Hydroxy-3-(2'-hydroxynaphthoyloxy)propylmethacrylat und o-, m- und p-Hydroxystyrol.

Als Monomereinheiten mit freien Carboxylgruppen kommen in Betracht Einheiten von Acrylsäure, Methacrylsäure, Maleinsäure, Itaconsäure, Vinylbenzoesäure, 4-(Acrylamido)benzoesäure und 4-(Methacrylamido)benzoesäure.

Neben den vernetzungsfähigen substituierten Methacrylamid- oder Acrylamideinheiten und den Einheiten mit freien Hydroxy- und/oder Carboxylgruppen können die Mischpolymerisate noch weitere Einheiten enthalten.

Beispiele für Verbindungen, die solche Einheiten liefern, sind Styrol, α-Chlorstyrol, α-Methylstyrol, 2-, 3- oder 4-Chlormethylstyrol, 4-Bromstyrol, Methylvinylether, Ethylvinylether, Propylvinylether, Butylvinylether, Acrylnitril, Acrolein, Butadien, die Methyl-, Ethyl-, Propyl-, Butyl-, Pentyl-, Hexyl-, 2-Ethylhexylester von Acrylsäure und Methacrylsäure, Vinylacetat, Vinylisobutylketon, Maleinsäureanhydrid, Ethylen und Propylen. Die Acrylsäure- und Methacrylsäureester, insbesondere solche mit 4 bis 12 Kohlenstoffatomen, sowie Styrol werden besonders bevorzugt.

Die beim Erhitzen des Gemischs erzielte Vernetzungsdichte hängt von der Menge der vernetzenden und vernetzbaren Gruppen im Polymermolekül sowie von dem Verhältnis von substituierten Säureamidgruppen zu den Carbonsäure- und bzw. oder OH-Gruppen ab. Vorteilhaft liegt das Molverhältnis $ROCH_2NR'$ zu COOH bzw. OH zwischen 0,1 und 1,5:1, bevorzugt bei 0,2-1,0 : 1.

Der Mengenanteil an Carboxylgruppen bzw. phenolische Hydroxygruppen enthaltenden Einheiten im Mischpolymerisat wird bestimmt durch die Forderung nach störungsfreier und möglichst rascher Entwicklung mit wäßrig-alkalischen Lösungen, die vorzugsweise frei von organischen Lösungsmitteln sind, und nach möglichst großer Entwicklerresistenz der unbelichteten Bereiche. Diese Eigenschaften werden auch durch das mittlere Molekulargewicht des Polymeren und die übrigen Komponenten der Schicht beeinflußt. Im allgemeinen sollte die Säurezahl bei Verwendung von Carboxylgruppen enthaltenden Einheiten im Bereich von 50 bis 300, bevorzugt zwischen 100 und 220, liegen.

Bei der Verwendung von Hydroxygruppen enthaltenden Einheiten sollte die entsprechende OH-Zahl im Bereich von 100 bis 400, bevorzugt zwischen 150 und 300 liegen. Wenn ein Entwickler verwendet werden kann, der organische Lösungsmittel enthält, kann die Säurezahl bzw. OH-Zahl auch kleiner sein.

Die bevorzugten Terpolymerisate enthalten normalerweise etwa 2 - 50, bevorzugt 5 - 40 Mol.-% an vernetzungsfähigen substituierten Säureamideinheiten. Der Mengenanteil an Carboxyl- und/oder OH-Einheiten entspricht den oben angegebenen Säure- bzw. OH-Zahlen. Werden ausschließlich Carboxygruppen enthaltende Einheiten verwendet, so liegt deren Anteil im allgemeinen bei 5 - 50, bevorzugt 10 - 40 Mol.-%. Für Mischpolymerisate mit OH-Einheiten liegt deren Anteil im

allgemeinen bei 20 - 95, bevorzugt 30 - 80 Mol.-%.

Das Molekulargewicht der Mischpolymerisate kann in weiten Grenzen variiert werden. Bevorzugt werden Polymerisate mit M = 500 - 200.000, besonders solche mit 2000 - 100.000. Die Bindemittel werden bevorzugt hergestellt durch Polymerisation in der Masse, durch Emulsions- oder Lösungspolymerisation der entsprechenden Monomeren in Gegenwart von kationischen oder radikalischen Initiatoren.

Zur Herstellung der erfindungsgemäßen Gemische wird das beschriebene Bindemittel kombiniert mit lichtempfindlichen Verbindungen bzw. Gemischen, deren Löslichkeit in einer wäßrig-alkalischen Entwicklerlösung beim Belichten erhöht wird. Hierzu gehören vor allem o-Chinondiazide und Kombinationen von photolytischen Säurespendern mit säurespaltbaren Verbindungen.

Als o-Chinondiazide werden bevorzugt Naphthochinon-(1,2)-diazid-(2)-4- oder -5-sulfonsäureester oder -amide verwendet. Von diesen werden die Ester, insbesondere die der 5-Sulfonsäuren, besonders bevorzugt. Geeignete Verbindungen dieser Art sind bekannt und z. B. in der DE-C 938 233, den DE-A 21 31 377, 25 47 905 und 28 28 017 beschrieben.

Die Menge an o-Chinondiazidverbindungen beträgt im allgemeinen 3 bis 50, bevorzugt 7 bis 35 Gew.-%, bezogen auf die nichtflüchtigen Anteile des Gemischs.

Auch Materialien auf Basis säurespaltbarer Verbindungen lassen sich mit gutem Effekt in dem erfindungsgemäßen Gemisch einsetzen.

Als durch Säure spaltbare Verbindungen sind in erster Linie zu nennen:

a) solche mit mindestens einer Orthocarbonsäureester- und bzw. oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können,

b) Oligomer- oder Polymerverbindungen mit wiederkehrenden Acetal- und/oder Ketalgruppierungen in der Hauptkette und

c) Verbindungen mit mindestens einer Enolether- oder N-Acylaminocarbonatgruppierung.

Durch Säure spaltbare Verbindungen des Typs a) als Komponenten strahlungsempfindlicher Gemische sind in der EP-A 0 022 571 ausführlich beschrieben; Gemische, die Verbindungen des Typs b) enthalten, sind in der DE-C 23 06 248 und der DE-C 27 18 254 beschrieben; Verbindungen des Typs c) werden in den EP-A 0 006 626 und 0 006 627 beschrieben.

Die Art und die Menge des Bindemittels und der spaltbaren Verbindung kann je nach Anwendungsart verschieden sein; bevorzugt werden Anteile des Bindemittels zwischen 30 und 90 Gew.-%, besonders bevorzugt 55 bis 85 Gew.-%. Der Anteil der spaltbaren Verbindung kann variiert werden zwischen 5 und 70 Gew.-%, bevorzugt werden 5 bis 40 Gew.-%.

Zusätzlich können noch zahlreiche andere Oligomere und Polymere mitverwendet werden, z. B. Phenolharze vom Novolaktyp oder Vinylpolymerisate wie Polyvinylacetale, Polymethacrylate, Polyacrylate, Polyvinylether und Polyvinylpyrrolidone, die selbst durch Comonomere modifiziert sein können.

Der günstigste Anteil an diesen Zusätzen richtet sich nach den anwendungstechnischen Erfordernissen und dem Einfluß auf die Entwicklungsbedingungen und beträgt im allgemeinen nicht mehr als 20 % vom Polymerisat mit vernetzenden Gruppen. In geringen Mengen kann die lichtempfindliche Schicht für spezielle Erfordernisse wie Flexibilität, Haftung, Glanz etc. außerdem noch Substanzen wie Polyglykole, Celluloseether, z. B. Ethylcellulose, Netzmittel, Farbstoffe und feinteilige Pigmente enthalten.

Als strahlungsempfindliche Komponenten, die beim Bestrahlen vorzugsweise starke Säuren bilden bzw. abspalten, sind eine große Anzahl von bekannten Verbindungen und Mischungen, wie Diazonium-, Phosphonium-, Sulfonium- und Jodonium-Salze, Halogen-Verbindungen, o-Chinondiazidsulfochloride und Organometall-Organohalogen-Kombinationen geeignet.

Die genannten Diazonium-, Phosphonium-, Sulfonium- und Jodonium-Verbindungen werden in der Regel eingesetzt in Form ihrer in organischen Lösungsmitteln löslichen Salze, meist als Abscheidungsprodukt mit komplexen Säuren wie Borfluorwasserstoffsäure, Hexafluorphosphor-, Hexafluorantimon- und -arsensäure.

Grundsätzlich sind als halogenhaltige strahlungsempfindliche und Halogenwasserstoffsäure bildende Verbindungen alle auch als photochemische Radikalstarter bekannten organischen Halogenverbindungen, beispielsweise solche mit mehr als einem Halogenatom an einem Kohlenstoffatom oder an einem aromatischen Ring, brauchbar. Beispiele sind in den US-A 3 515 552, 3 536 489 und 3 779 778, der DE-C 26 10 842 und den DE-A 22 43 621, 27 18 259 und 33 37 024 beschrieben. Von diesen Verbindungen werden die s-Triazinderivate mit 2 Halogenmethylgruppen, insbesondere Trichlormethylgruppen, und einem aromatischen bzw. ungesättigten Substituenten im Triazinkern, wie sie in den DE-A 27 18 259 und 33 37 024 beschrieben sind, bevorzugt. Die Wirkung dieser halogenhaltigen Verbindungen kann auch durch bekannte Sensibilisatoren spektral beeinflußt und gesteigert werden.

Beispiele für geeignete Säurespender sind: 4-(Di-n-propylamino)-benzoldiazoniumtetrafluoroborat, 4-p-Tolylmercapto-2,5-diethoxy-benzoldiazoniumhexafluorophosphat und -tetrafluoroborat, Diphenylamin-4-diazoniumsulfat, 4-Methyl-6-trichlormethyl-2-pyron, 4-(3,4,5-Trimethoxystyryl)-6-trichlormethyl-2-pyron, 4-(4-Methoxy-styryl)-6-(3,3,3-trichlor-propenyl)-2-pyron, 2-Trichlormethylbenzimidazol, 2-Tribrommethyl-chinolin, 2,4-Dimethyl-1-tribromacetyl-benzol, 3-Nitro-1-tribromacetyl-benzol, 4-Dibromacetyl-benzoesäure, 1,4-Bis-dibrommethyl-benzol, Tris-dibrommethyl-s-triazin, 2-(6-Methoxy-naphth-2-yl)-, 2-(Naphth-1-yl)-, 2-(Naphth-2-yl)-, 2-(4-Ethoxyethyl-naphth-1-yl)-, 2-(Benzopyran-3-yl)-, 2-(4-Methoxyanthrac-1-yl)-, 2-(4-Styryl-phenyl)-, 2-(Phenanthr-9-yl)-4,6-bis-trichlormethyl-s-triazin und die in den Beispielen angeführten Verbindungen.

Die Menge des Säurespenders kann je nach seiner chemischen Natur und der Zusammensetzung des Gemischs ebenfalls sehr verschieden sein. Günstige Ergebnisse werden erhalten mit etwa 0,1 bis 10 Gew.-%, bezogen auf den Gesamtfeststoff, bevorzugt sind 0,2 bis 5 %. Besonders für Kopierschichten von Dicken über 10 µm empfiehlt es sich, relativ wenig Säurespender zu verwenden.

Schließlich können dem lichtempfindlichen Gemisch noch lösliche oder auch feinteilige dispergierbare Farbstoffe sowie je nach Anwendungszweck auch UV-Absorber zugesetzt werden. Als Farbstoffe haben sich die Triphenylmethanfarbstoffe, insbesondere in der Form ihrer Carbinolbasen, besonders bewährt. Die günstigsten Mengenverhältnisse der Komponenten lassen sich im Einzelfall durch Vorversuche leicht ermitteln.

Als Schichtträger für die lichtempfindlichen Gemische eignen sich alle üblicherweise in der Technik in Kopierprozessen eingesetzten Materialien. Als Beispiele seien Kunststoffolien, Isolierplatten mit Kupferauflage, mechanisch oder elektrochemisch aufgerauhtes und ggf. anodisiertes Aluminium, Holz, Keramik, Glas und Silicium, dessen Oberfläche chemisch z. B. in Siliciumnitrid oder Siliciumdioxid umgewandelt sein kann, genannt.

Bevorzugte Träger für dicke Schichten über 10 um sind Kunststoffolien, die dann als temporäre Träger für Transferschichten dienen. Dafür und für Farbfolien werden Polyesterfolien, z. B. aus Polyethylenterephthalat, bevorzugt. Polyolefinfolien wie Polypropylen sind jedoch ebenfalls geeignet. Als Schichtträger für Schichtdicken unter ca. 10 µm werden meist Metalle verwendet. Für Offsetdruckplatten können eingesetzt werden: mechanisch oder chemisch aufgerauhtes und gegebenenfalls anodisiertes Aluminium, das zudem noch chemisch, z. B. mit Polyvinylphosphonsäure, Silikaten oder Phosphaten, vorbehandelt sein kann.

Schließlich kann die Beschichtung direkt oder durch Schichtübertragung vom temporären Schichtträger erfolgen auf Leiterplatten-Materialien, die aus Isolierplatten mit ein- oder beidseitiger Kupferauflage bestehen, auf Glas oder Keramik-Materialien, die gegebenenfalls haftvermittelnd vorbehandelt sind, und auf Silicium-Scheiben. Außerdem können Holz, Textilien und Oberflächen vieler Werkstoffe beschichtet werden, die vorteilhaft durch Projektion bebildert werden und resistent gegen die Einwirkung alkalischer Entwickler sind.

Das erfindungsgemäße Gemisch ist lagerstabil sowohl in Lösung als auch in fester Form als Trockenresist. Es läßt sich auch nach monatelanger Lagerung einwandfrei und problemlos verarbeiten. Gegenüber frisch hergestellten Schichten zeigen sich keine Unterschiede bezüglich Laminierbarkeit, Entwickelbarkeit und Entwicklerresistenz.

Zum Belichten können die üblichen Lichtquellen wie Röhrenlampen, Xenonimpulslampen, metallhalogeniddotierte Quecksilberdampf-Hochdrucklampen und Kohlebogenlampen verwendet werden.

Unter Bestrahlung ist in dieser Beschreibung die Einwirkung aktinischer elektromagnetischer Strahlung im Wellenlängenbereich unterhalb etwa 500 nm zu verstehen. Alle in diesem Wellenlängenbereich emittierenden Strahlungsquellen sind prinzipiell geeignet.

Mit Vorteil können auch Laserbestrahlungsgeräte, insbesondere automatische Verarbeitungsanlagen verwendet werden, die als Strahlungsquelle einen Argon-Ionen-Laser enthalten.

Die Bestrahlung kann auch mit Elektronenstrahlen erfolgen. In diesem Falle können auch im üblichen Sinne nicht lichtempfindliche Säure bildende Verbindungen als Initiatoren der Solubilisierungsreaktion eingesetzt werden, z. B. halogenierte aromatische Verbindungen oder halogenierte polymere Kohlenwasserstoffe. Auch Röntgenstrahlen können zur Bilderzeugung verwendet werden.

Die bildmäßig belichtete oder bestrahlte Schicht kann in bekannter Weise mit praktisch den gleichen Entwicklern wie für handelsübliche Naphthochinondiazid-Schichten und Kopierlacke entfernt werden, oder die neuen Materialien können in ihrem Kopierverhalten mit Vorteil auf die bekannten Hilfsmittel wie Entwickler und programmierte Sprühentwicklungsgeräte abgestimmt werden. Die wäßrigen Entwicklerlösungen können z. B. Alkaliphosphate, -silikate oder -hydroxide und ferner Netzmittel sowie ggf. kleinere Anteile organischer Lösungsmittel enthalten. In bestimmten Fällen sind auch Lösungsmittel-Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden.

Der Einsatz von positiv arbeitenden Materialien bietet den Vorteil, nach der ersten bildmäßigen

Belichtung die noch verbleibende Resistschicht nach gegebenenfalls durchgeführten Ätz- oder Metallabscheidungsprozessen durch erneute Belichtung weiter zu differenzieren.

Fertig präparierte, nach den eben beschriebenen Verfahrensschritten abgedeckte Schichtträger, wie Leiterplatten oder Siliciumscheiben, können einer Temperaturbehandlung unterzogen werden, wobei die Schicht thermisch gehärtet wird.

Es wird angenommen, daß sich hierbei ein interpenetrierendes Netzwerk ausbildet, das die guten mechanischen, thermischen und chemischen Eigenschaften bewirkt. Diese thermische Behandlung erfolgt im allgemeinen zwischen 80 und 200 °C, bei ungefähren Behandlungszeiten von 5 bis 60 Minuten.

Die erfindungsgemäßen Gemische ergeben Resistformulierungen, die sich einerseits durch eine hohe Flexibilität und mechanische Festigkeit im unbelichteten Zustand auszeichnen, andererseits im gehärteten Zustand eine hohe Temperaturresistenz aufweisen. So lassen sich derartige Schichten je nach Anforderung mehrmals differenzieren und schließlich bei Bedarf härten. Die gehärteten Masken sind gegenüber atmosphärischen, thermischen und insbesondere chemischen Einflüssen über längere Zeiträume beständig.

Obwohl die Erfindung in der vorstehenden Beschreibung bevorzugt in ihrer Anwendung auf die Herstellung von Resistmasken beschrieben wurde, ist sie nicht auf diese Anwendung beschränkt. Sie ist in allen Fällen anwendbar, wo es darauf ankommt, bildmäßige Schablonen von besonders hoher thermischer, mechanischer und chemischer Resistenz zu erzeugen. Das ist der Fall auch bei anderen Photoresistanwendungen, z. B. bei der Erzeugung von Lötstopmasken, die gegenüber aggressiven Bädern und/oder bei erhöhten Temperaturen resistent sein sollen.

Die Verarbeitung des Gemischs erfolgt bevorzugt nach der Trockenphotoresisttechnik. Das Gemisch eignet sich aber auch gut zur Verarbeitung nach der Flüssigresisttechnik, d. h. durch Aufbringen einer Lösung der Bestandteile auf den endgültigen Schichtträger sowohl bei der Leiterplattenfertigung als auch bei der Herstellung von Lötstopmasken.

Das erfindungsgemäße Gemisch ist auch zur Herstellung von Offsetdruckplatten, z. B. auf Aluminium, Stahl oder Chrom als Trägermaterial, geeignet, die in bekannter Weise nach dem Entwickeln zur Verfestigung der Bildschablone eingebrannt werden sollen. Dieses Verfahren ist in der GB-A 1 154 749 beschrieben. Bei dieser Anwendungsweise sollte allerdings kürzere Zeit und auf höhere Temperaturen erhitzt werden, im allgemeinen 2 bis 20 Minuten auf Temperaturen im Bereich von 160 bis 250 °C. Hierdurch kann die Druckauflage wesentlich gesteigert werden.

Die folgenden Beispiele erläutern einzelne Ausführungsformen des erfindungsgemäßen Gemischs. Wenn nichts anderes angegeben ist, sind Prozentzahlen und Mengenverhältnisse in Gewichtseinheiten zu verstehen. Die Mengen sind in den Rezepturen in Gewichtsteilen (Gt) angegeben.

Beispiel 1

Es wurden Beschichtungslösungen hergestellt aus:

12 Gt eines der folgenden Terpolymerisate

a) N-(4-Hydroxyphenyl)methacrylamid, Styrol, N-Butoxymethylmethacrylamid (50:40:10), OH-Zahl: 170,

b) N-(4-Hydroxyphenyl)methacrylamid, Butylmethacrylat, N-Butoxymethylmethacrylamid (45:30:25), OH-Zahl 143,

c) 4-Hydroxystyrol, Styrol, N-Butoxymethylmethacrylamid (70:20:10), OH-Zahl: 310,

3 Gt eines Polyacetals aus Triethylenglykol und Butyraldehyd,

| | |
|---|---|
| 0,1 Gt | 2-(4-Styrylphenyl)-4,6-bis-trichlormethyl-s-triazin und |
| 0,015 Gt | Kristallviolettbase in |
| 400 Gt | Ethanol und |
| 250 Gt | Butanon. |

Mit den angegebenen Lösungen wurde jeweils eine einseitig durch Drahtbürsten mechanisch aufgerauhte Aluminiumplatte beschichtet und im Trokkenschrank fünf Minuten bei 80 °C getrocknet.

Das auf diese Weise vorsensibilisierte Material wurde 8 Sekunden unter einer 5 kW-Metallhalogenidlampe belichtet und nach einer Wartezeit von 10 Minuten mit der folgenden Lösung entwickelt:

| | |
|---|---|
| 5,3 Gt | Natriummetasilikat x 9 Wasser, |
| 3,4 Gt | Trinatriumphosphat x 12 Wasser, |
| 0,3 Gt | Natriumdihydrogenphosphat (wasserfrei), |
| 91,0 Gt | Wasser. |

Durch die Entwicklung werden die vom Licht getroffenen Anteile der Kopierschicht entfernt, und es bleiben die unbelichteten Bildstellen auf dem Schichtträger zurück. Von einer so hergestellten Druckform konnten in einer Offsetdruckmaschine 100.000 einwandfreie Drucke hergestellt werden.

Zur Erhöhung der Druckauflage und Verfestigung der Druckschablone wurde die Druckform einer Wärmebehandlung unterzogen. Zu diesem Zweck wurde die getrocknete Druckform nach dem Entwickeln in einem Einbrennofen 5 Minuten auf 190 °C erhitzt. Durch das Erhitzen der Druckform wurde die Schicht vernetzt und somit gehärtet. Dies äußert sich in einer Erhöhung der Druckauflage auf 300.000. Ein Tonen der Druckplatte, was auf einen Austritt von niedermolekularen Schichtbestandteilen hindeuten würde, konnte nicht beobachtet werden. Die gehärtete Druckschablone ist resistent gegenüber Chemikalien und damit unlöslich in organischen Lösungsmitteln wie Aceton, Alkoholen, Dimethylformamid, Essigester, Toluol oder Xylol.

Beispiel 2

Es wurde eine Beschichtungslösung hergestellt aus:

4,4 Gt eines Copolymeren aus N-(4-Hydroxyphenyl)-N-methylacrylamid, Styrol und N-Butoxymethylmethacrylamid (55:25:20), OH-Zahl: 220,
4,4 Gt eines Kresol-Formaldehyd-Novolaks mit einem Erweichungspunkt von 105-120 °C und
1,1 Gt des Veresterungsproduktes aus 1 mol 2,3,4-Trihydroxybenzophenon und 3 mol Naphthochinon-(1,2)-diazid-(2)-5-sulfonsäurechlorid in
45 Gt Butanon und
45 Gt Ethanol.

Die Lösung wurde anschließend durch ein Filter mit einem Porendurchmesser von 0,2 µm (Millipore) filtriert und dann auf einen oberflächlich orydierten Wafer aufgeschleudert und getrocknet. Es resultierte eine Schichtdicke von ca. 1,6 µm. Nach 10 Minuten Trocknen der Schicht bei 60 °C wurde der Wafer im Kontakt mit einer Testbildmaske 15 Sekunden mit einer Intensität von 4,5 $mW/cm^2$ bei 365 nm belichtet und mit der in Beispiel 1 angegebenen Lösung entwickelt. Das erhaltene Bildmuster zeigte eine Auflösung von ca. 1,0 µm.

Anschließend wurde die Resistschablone 30 Minuten bei 150 °C getempert. Die Untersuchung der Strukturen im Mikroskop zeigte keine Abrundungen der Kanten und kein Verlaufen der Linien. Dies scheint auf eine Reaktion des polymer gebundenen Vernetzers mit dem Novolak hinzudeuten; offenbar setzt diese Reaktion bereits unterhalb der Fließtemperatur des Novolaks ein. Aufgrund dieser hohen thermischen Beständigkeit eignen sich derartig strukturierte Wafer besonders für nachfolgende Trockenätzprozesse.

Zum Vergleich wurde eine ähnliche Beschichtungslösung, die anstelle des Copolymeren weitere 4,4 Gt Novolak enthielt, in gleicher Weise verarbeitet und bei 150 °C getempert. Unter dem Mikroskop war in Bereichen sehr feiner Linienführungen ein deutliches Verlaufen der Resistlinien zu erkennen, das in Einzelfällen bis zur Vereinigung führte.

Beispiel 3

Eine Photoresistlösung aus

8,9 Gt eines Copolymeren aus 4-Hydroxystyrol, Styrol und N-Butoxymethylmethacrylamid (68:22:10), OH-Zahl: 295 und
1,1 Gt des Veresterungsproduktes aus 1 mol 2,3,4-Trihydroxy-benzophenon und 3 mol Naphthochinon-(1,2)-diazid-(2)-5-sulfonsäurechlorid in
45 Gt Butanon und
45 Gt Ethanol

wurde analog Beispiel 2 auf einen Wafer aufgeschleudert und belichtet.

Auch in diesem Fall erhielt man eine thermisch härtbare Schicht, die nach der Wärmebehandlung eine hervorragende Resistenz gegenüber Temperatur und aggressiven Materialien, z. B. HF-Plasma, besitzt.

Beispiel 4

Zur Herstellung eines Positiv-Trockenresists wurden

40 Gt eines Copolymeren aus 4-Hydroxystyrol, n-Hexylmethecrylat und N-Butoxymethylmethacrylamid (65:25:10), OH-Zahl: 270,
11,7 Gt des in Beispiel 1 angegebenen Polyacetals,
0,5 Gt 2-(4-Ethoxy-naphth-1-yl)-4,6-bis-trichlormethyl-s-triazin und
0,1 Gt Kristallviolettbase in
50 Gt Ethanol und
30 Gt Butanon

gelöst. Diese Lösung wurde auf eine 26 µm dicke, biaxial verstreckte und thermofixierte Polyethylenterephthalatfolie aufgeschleudert und anschließend 10 Minuten bei 60 °C nachgetrocknet. Es resultierte eine Schichtdicke von 25 µm. Zum Schutz gegen Staub und Verkratzungen wurde darauf noch eine Polyethylendeckfolie kaschiert.

Zur Herstellung von Leiterplatten wurde dieser Trockenresistfilm nach Abziehen der Deckfolie in einem handelsüblichen Laminator auf einen gereinigten, vorgewärmten Träger, der aus einem Isolierstoffmaterial mit 35 µm dicker Kupferauflage bestand, laminiert. Nach Abziehen der Trägerfolie und Nachtrocknen wurde unter einer Vorlage mit einer 5-kW-Metallhalogenidlampe (110 cm Abstand) ca. 90 Sekunden belichtet und - nach einer Wartezeit von 10 Minuten - 1 Minute in dem in Beispiel 1 angegebenen Entwickler entwickelt.

Die entstandene Resistschablone wurde 30 Minuten bei 150 °C getempert. Bei darauffolgenden Ätzprozessen oder Behandlung in aggressiven Bädern (z. B. Nickel- oder Goldgalvanik) zeigte sich keine Veränderung der Resistschicht. Zur Prüfung der Lösemittelresistenz wurde die gehärtete Schicht 8 Stunden in Isopropanol belassen. Danach wies die Schicht keinerlei Angriff auf. Alternativ dazu läßt sich die Resistschicht nach einem ersten

Differenzierungs- und Galvanoprozeß erneut belichten, entwickeln und anschließend thermisch härten.

Beispiel 5

Beispiel 4 wurde wiederholt, wobei anstelle des angegebenen Copolymeren ein Copolymeres aus N-(4-Hydroxyphenyl)methacrylamid, n-Hexylmethacrylat und N-Butoxymethylmethacrylamid (40:45:15; OH-Zahl: 162) verwendet wurde. Auch in diesem Fall erhielt man einen positiv arbeitenden Trockenresist, der sich nach Belichten und Entwikkeln thermisch härten ließ.

Beispiel 6

Zur Herstellung einer Offsetdruckform wurde die folgende Beschichtungslösung hergestellt:

| | |
|---|---|
| 1,5 Gt | eines Copolymeren aus Methacrylsäure, Styrol und N-Butoxymethylmethacrylamid (30:50:20), Säurezahl: 158, |
| 7,4 Gt | des in Beispiel 2 angegebenen Novolaks und |
| 1,1 Gt | des in Beispiel 2 angegebenen Naphthochinondiazids in |
| 45 Gt | Butanon und |
| 45 Gt | Ethanol. |

Mit dieser Beschichtungslösung wurde eine elektrochemisch aufgerauhte und anodisierte Aluminiumplatte beschichtet, deren Oberfläche mit einer wäßrigen Lösung von Polyvinylphosphonsäure behandelt worden war. Die so hergestellte Druckplatte wurde unter einer transparenten Positivvorlage bildmäßig belichtet und anschließend mit der in Beispiel 1 angegebenen Lösung entwickelt. Nach thermischer Härtung (5 Minuten bei 180 °C) erlaubt die so hergestellte Druckform eine hohe Druckauflage.

Beispiel 7

Eine Lösung aus

| | |
|---|---|
| 2,8 Gt | eines Copolymeren aus Methacrylsäure, Styrol und N-Butoxymethylmethacrylamid (35:50:15), Säurezahl: 173, |
| 17,2 Gt | des in Beispiel 2 angegebenen Novolaks und |
| 2,5 Gt | des in Beispiel 2 angegebenen Naphthochinondiazids in |
| 85 Gt | Butanon |

wurde nach Filtrieren durch ein 0,2 µm Filter auf einen Wafer oufgeschleudert. Nach 30 Minuten Trocknen bei 60 °C im Umlufttrockenschrank betrug die Schichtdicke 1,6 µm. Es wurde dann mit einer Intensität von 5 $mW/cm^2$ bei 365 nm im Kontakt belichtet und mit der in Beispiel 1 angegebenen Lösung entwickelt. Nach der thermischen Härtung von 30 Minuten bei 100 °C und danach 15 Minuten bei 150 °C wiesen die Resiststrukturen keinerlei Verzerrungen auf.

Beispiel 8

Zur Herstellung eines Positiv-Trockenresists wurden

| | |
|---|---|
| 40 Gt | eines Copolymeren aus 4-Hydroxyphenylmethacrylat, 2-Ethyl-hexylmethacrylat und N-Butoxy-methyl-methacrylamid (68:20:12), OH-Zahl: 230, |
| 8,5 Gt | Bis-(5-Ethyl-5-butyl-1,3-dioxan-2-yl)-ether des 2-Ethyl-2-butyl-1,3-propandiols, |
| 0,5 Gt | des in Beispiel 4 angegebenen Triazins, |
| 0,05 Gt | Kristallviolett-Base in |
| 50 Gt | Ethanol und |
| 30 Gt | Butanon |

gelöst. Diese Lösung wurde entsprechend Beispiel 4 auf eine Polyethylenterephthalatfolie geschleudert. Es resultierte eine Schichtdicke von 32 µm.

Nach 10 Minuten Trocknen bei 60 °C wurde dieser Trockenresistfilm auf ein kupferkaschiertes Basismaterial laminiert und nach Abziehen der Trägerfolie 40 Sekunden unter einer Vorlage belichtet. Nach einer Wartezeit von 10 Minuten wurde 1 Minute in dem in Beispiel 1 angegebenen Entwickler entwickelt.

Nach galvanischer Abscheidung von Cu und anschließend von Pb/Sn an den freigelegten Bereichen wurde die Platte erneut 40 Sekunden belichtet und 1 Minute entwickelt. Anschließend wurde 15 Minuten bei 150 °C getempert. Danach wurden durch Ätzen mit ammoniakalischer Cu-(II)-chlorid-Lösung die freigelegten Stellen entfernt. Es lassen sich damit z. B. Leiterplatten in Kupfertechnik herstellen mit selektiver Abscheidung von Cu und Pb/Sn an den Montagelöchern und Leiterzügen aus Kupfer.

## Patentansprüche

**1.** Strahlungsempfindliches Gemisch, das

A) ein in Wasser unlösliches, in wäßrig-alkalischen Lösungen lösliches polymeres Bindemittel und

B) ein 1,2-Chinondiazid oder eine Kombination aus

1.) einer unter Einwirkung von aktinischer Strahlung eine starke Säure bildenden Verbindung und

2.) einer Verbindung mit mindestens einer spaltbaren C-O-C-Bindung enthält, deren Löslichkeit in einem flüssigen Entwickler durch Einwirkung von Säure erhöht wird,
dadurch gekennzeichnet, daß es als Bindemittel ein Polymeres mit seitenständigen vernetzenden Gruppen der Formel $-CH_2OR$ enthält, worin R ein Wasserstoffatom, eine niedere Alkyl-, Acyl- oder Hydroxyalkylgruppe ist.

**2.** Strahlungsempfindliches Gemisch nach Anspruch 1, dadurch gekennzeichnet, daß das Polymere ein Mischpolymerisat mit Einheiten der Formel I

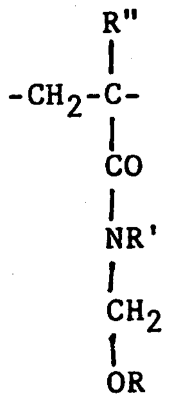

ist, worin
R' ein Wasserstoffatom oder eine Alkylgruppe,
R'' ein Wasserstoffatom oder eine Methylgruppe ist und
R die oben angegebene Bedeutung hat.

**3.** Strahlungsempfindliches Gemisch nach Anspruch 2, dadurch gekennzeichnet, daß das Mischpolymerisat ferner Einheiten mit seitenständigen Carboxylgruppen enthält.

**4.** Strahlungsempfindliches Gemisch nach Anspruch 2, dadurch gekennzeichnet, daß das Mischpolymerisat ferner Einheiten mit seitenständigen phenolischen Hydroxygruppen enthält.

**5.** Strahlungsempfindliches Gemisch nach Anspruch 4, dadurch gekennzeichnet, daß die Einheiten mit seitenständigen phenolischen Hydroxygruppen Einheiten von Hydroxystyrol, einem N-(Hydroxyphenyl)acrylamid oder -methacrylamid oder einem Hydroxyphenylacrylat oder -methacrylat sind.

**6.** Strahlungsempfindliches Gemisch nach Anspruch 3, dadurch gekennzeichnet, daß die Einheiten mit seitenständigen Carboxylgruppen Acryl- oder Methacrylsäureeinheiten sind.

**7.** Strahlungsempfindliches Gemisch nach einem der Ansprüche 3 bis 6, dadurch gekennzeichnet, daß das Mischpolymerisat zusätzlich Einheiten von Styrol, einem Styrolderivat, einem Alkylacrylat oder -methacrylat enthält.

**8.** Strahlungsempfindliches Gemisch nach Anspruch 7, dadurch gekennzeichnet, daß die zusätzlichen Einheiten von einem Alkylmethacrylat mit 4 bis 12 Kohlenstoffatomen in der Alkylgruppe abgeleitet sind.

**9.** Strahlungsempfindliches Aufzeichnungsmaterial mit einem Schichtträger und einer strahlungsempfindlichen Schicht, dadurch gekennzichnet, daß die strahlungsempfindliche Schicht ein strahlungsempfindliches Gemisch gamäß einem oder mehreren der Ansprüche 1 bis 8 enthält.

**10.** Verfahren zur Herstellung von wärmebeständigen Reliefaufzeichnungen, bei dem man ein strahlungsempfindliches Aufzeichnungsmaterial gemäß Anspruch 9 bildmäßig belichtet, mit einer wäßrig-alkalischen Entwicklerlösung entwickelt und das erhaltene Reliefbild auf erhöhte Temperatur erwärmt, dadurch gekennzeichnet, daß man die entwickelte Schicht 2 bis 60 Minuten auf eine Temperatur im Bereich von 80 bis 250 °C erwärmt.

## Claims

**1.** A radiation-sensitive composition comprising
A) a polymeric binder which is insoluble in water and soluble in aqueous-alkaline solutions; and
B) a 1,2-quinonediazide or a combination of
1. a compound which, under the action of actinic radiation, forms a strong acid and
2. a compound which possesses at least one cleavable C-O-C bond, the solubility of which in a liquid developer is increased by the action of acid,
wherein the binder is a polymer possessing crosslinking side groups of the formula $-CH_2OR$, in which R denotes a hydrogen atom or a lower alkyl group, acyl group or hydroxyalkyl group.

**2.** A radiation-sensitive composition as claimed in Claim 1, wherein the polymer is a copolymer possessing units of the formula I

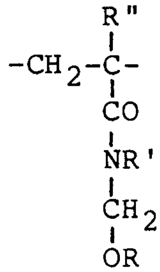

in which

- R' denotes a hydrogen atom or an alkyl group,
- R'' denotes a hydrogen atom or a methyl group, and
- R has the above-indicated meaning.

**3.** A radiaton-sensitive composition as claimed in Claim 2, wherein the copolymer further comprises units having lateral carboxyl groups.

**4.** A radiation-sensitive composition as claimed in Claim 2, wherein the copolymer further comprises units having lateral phenolic hydroxy groups.

**5.** A radiation-sensitive composition as claimed in Claim 4, wherein the units having lateral phenolic hydroxy groups are units of hydroxystyrene, an N-(hydroxyphenyl)acrylamide, an N-(hydroxyphenyl) methacrylamide, a hydroxyphenyl acrylate or a hydroxyphenyl methacrylate.

**6.** A radiation-sensitive composition as claimed in Claim 3, wherein the units having lateral carboxyl groups are units of acrylic or methacrylic acid.

**7.** A radiation-sensitive composition as claimed in any of Claims 3 to 6, wherein the copolymer additionally comprises units of styrene, a styrene derivative, an alkyl acrylate or an alkyl methacrylate.

**8.** A radiation-sensitive composition as claimed in Claim 7, wherein the additional units are derived from an alkyl methacrylate having 4 to 12 carbon atoms.

**9.** A radiation-sensitive recording material comprised of a layer support and a radiation-sensitive layer, wherein said radiation-sensitive layer comprises a radiation-sensitive composition as claimed in one or several of claims 1 to 8.

**10.** A process for producing heat-resistant recorded relief images, in which a radiation-sensitive recording material as claimed in claim 9 is imagewise exposed and developed with an aqueous-alkaline developer solution, and the resulting relief image is heated to an elevated temperature, wherein the developed layer is heated to a temperature within the range of 80 °C to 250 °C for a period of 2 to 60 minutes.

**Revendications**

**1.** Composition photosensible comprenant
A) un liant polymère insoluble dans l'eau et soluble dans des solutions alcalines aqueuses, et
B) un 1,2-quinonediazide ou une combinaison de
1) un composé qui forme un acide fort, sous l'effet d'un rayonnement actinique, et
2) un composé avec au moins une liaison C-O-C clivable, dont la solubilité dans un développateur liquide est augmentée par action d'acide,
caractérisée en ce qu'elle contient, comme liant, un polymère à groupes latéraux réticulants, de formule $-CH_2OR$, dans laquelle R représente un atome d'hydrogène ou un groupe alkyle, acyle ou hydroxyalkyle inférieur.

**2.** Composition photosensible selon la revendication 1, caractérisée en ce que le polymère est un copolymère comportant des motifs de formule I

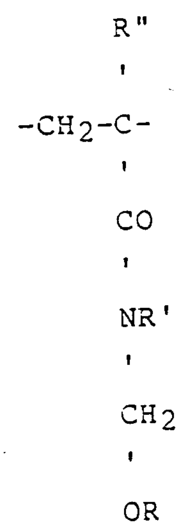

dans laquelle

- R' représente un atome d'hydrogène ou un groupe alkyle,
- R'' représente un atome d'hydrogène ou

un groupe méthyle, et
R a la définition indiquée ci-dessus.

**3.** Composition photosensible selon la revendication 2, caractérisée en ce que le copolymère renferme en outre des motifs comportant des groupes carboxyle latéraux.

**4.** Composition photosensible selon la revendication 2, caractérisée en ce que le copolymère renferme en outre des motifs comportant des groupes hydroxy phénoliques latéraux.

**5.** Composition photosensible selon la revendication 4, caractérisée en ce que les motifs comportant des groupes hydroxy phénoliques latéraux sont des motifs d'hydroxystyrène, d'un N-(hydroxyphényl)acrylamide ou d'un N-(hydroxyphényl)méthacrylamide ou d'un acrylate ou méthacrylate d'hydroxyphényle.

**6.** Composition photosensible selon la revendication 3, caractérisée en ce que les motifs comportant des groupes carboxyle latéraux sont des motifs acide acrylique ou métriacrylique.

**7.** Composition photosensible selon l'une des revendications 3 à 6, caractérisée en ce que le copolymère renferme en outre des motifs de styrène, d'un dérivé du styrene, d'un acrylate ou méthacrylate d'alkyle.

**8.** Composition photosensible selon la revendication 7, caractérisée en ce que les motifs supplémentaires proviennent d'un méthacrylate d'alkyle comportant de 4 à 12 atomes de carbone dans le groupe alkyle.

**9.** Matériel d'enregistrement photosensible comprenant un support de couche et une couche photosensible, caractérisé en ce que la couche photosensible est une composition photosensible selon une ou plusieurs des revendications 1 à 8.

**10.** Procédé de fabrication d'images en relief résistantes à la chaleur, dans lequel on expose à la lumière, selon l'image, un matériel d'enregistrement photosensible de la revendication 9, on le développe avec une solution alcaline aqueuse de développateur et on chauffe à une température élevée l'image en relief obtenue, caractérisé en ce que l'on chauffe à une température de 80 à 250 °C, pendant 2 à 60 minutes, la couche développée.